(19) Europäisches Patentamt / European Patent Office / Office européen des brevets

(11) **EP 4 661 242 A1**

(12) **EUROPEAN PATENT APPLICATION**
published in accordance with Art. 153(4) EPC

(43) Date of publication:
**10.12.2025 Bulletin 2025/50**

(21) Application number: **24845990.1**

(22) Date of filing: **22.07.2024**

(51) International Patent Classification (IPC):
*H02J 7/00* (2006.01)   *H01M 10/44* (2006.01)
*B60L 53/60* (2019.01)   *G01R 31/36* (2020.01)
*G01R 31/382* (2019.01)   *G01R 31/396* (2019.01)

(52) Cooperative Patent Classification (CPC):
**B60L 53/60; G01R 31/36; G01R 31/382;**
**G01R 31/396; H01M 10/44; H02J 7/00;** Y02E 60/10

(86) International application number:
**PCT/KR2024/010574**

(87) International publication number:
**WO 2025/023688 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.07.2023 KR 20230098508**

(71) Applicant: **LG Energy Solution, Ltd.**
**Seoul 07335 (KR)**

(72) Inventors:
• **CHOI, Dong-In**
**Daejeon 34122 (KR)**
• **PARK, Tae-Soon**
**Daejeon 34122 (KR)**
• **LEE, Ji-Eun**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **METHOD AND APPARATUS FOR CHARGING BATTERY**

(57) A battery charging method according to an embodiment of the present disclosure is a method of charging a battery by dividing a charging section into a plurality of charging sections, and includes a first discharging step of applying a first discharging pulse between an n-1th (n is a natural number greater than or equal to 2) charging section and an nth charging section; and a second discharging step of applying a second discharging pulse between the nth charging section and an n+1th charging section. Here, a discharging rate of the second discharging pulse is less than a discharging rate of the first discharging pulse.

FIG. 3

EP 4 661 242 A1

**Description**

TECHNICAL FIELD

The present application claims priority to Korean Patent Application No. 10-2023-0098508 filed on July 27, 2023 in the Republic of Korea, the disclosures of which are incorporated herein by reference.

The present disclosure relates to a battery charging method and apparatus, and more specifically, to a battery charging method and apparatus capable of maximizing the charging efficiency of a battery by applying a discharging pulse to a charging process so that the environment in which the discharging pulse is applied is differentiated.

BACKGROUND ART

As the demand for portable electronic products such as laptops, video cameras, and mobile phones that use electricity as a power source increases rapidly, and as mobile robots, electric bicycles, electric carts, and electric vehicles become more widely commercialized, research on high-performance secondary batteries that can be repeatedly charged and discharged is actively being conducted.

Commercialized secondary batteries include nickel-cadmium batteries, nickel-metal hydride batteries, nickel-zinc batteries, and lithium secondary batteries. Among them, lithium secondary batteries have the advantage of being free to charge and discharge and having a very low self-discharge rate compared to nickel-based secondary batteries, due to almost no memory effect. In addition, lithium secondary batteries have the characteristics of high energy density and high operating voltage, and thus are being studied more intensively than other types of secondary batteries and are being applied more widely in actual products.

Recently, secondary batteries are widely used not only in small devices such as portable electronic devices, but also in medium and large-sized devices such as electric vehicles and energy storage systems (ESSs).

In this case, a battery module in which a number of electrically connected secondary batteries are stored together inside a module case is mainly applied, and furthermore, when high power or large capacity is required, a battery pack in which a number of such battery modules are electrically connected is also applied.

For secondary battery cells, cell assemblies, battery modules, or battery packs (hereinafter, collectively referred to as "batteries"), power efficiency and safety are important factors, so research is actively being conducted on BMS, which monitors the electrical characteristics of the battery and performs feedback control such as charging and discharging using the monitoring results.

Meanwhile, various studies are being conducted on battery charging, such as rapid charging, to more effectively reflect users' needs and improve the overall environment due to the high capacity of batteries.

The methods used to charge batteries include constant current-constant voltage (CC-CV) charging, pulse charging, boost charging, and multi-step CC charging.

When charging a battery in a high current environment to shorten the charging time, a lithium plating (Li-plating) phenomenon may occur in which lithium cations ($Li^+$) supplied to the negative electrode are not quickly absorbed by the negative electrode and accumulate on the negative electrode and are precipitated as lithium metal.

This phenomenon causes side reactions with the electrolyte, changes in the kinetic balance of the battery, etc., and is the main cause of decreased battery performance, decreased capacity, and even deterioration or reduced lifespan of the battery.

In addition, if this phenomenon occurs, non-uniform lithium crystals (Li-dendrite) are formed, which increases the possibility of a short circuit, which may lead to fatal safety problems such as fire and explosion.

DISCLOSURE

Technical Problem

The present disclosure is designed to solve the problems of the related art, and therefore the present disclosure is directed to providing a battery charging method and apparatus that may fundamentally solve the problem of lithium precipitation and further optimize charging efficiency such as rapid charging by applying a discharging mode that applies a discharging pulse between charging sections divided into a plurality of sections so that the discharging environment of each discharging mode is differentiated.

The technical problems to be solved by the present disclosure are not limited to the above, and other problems not mentioned herein will be clearly understood by those skilled in the art from the following description.

Technical Solution

A battery charging method according to an aspect of the present disclosure is a method of charging a battery by dividing a charging section into a plurality of charging sections, and may include a first discharging step of applying a first discharging pulse between an n-1th (n is a natural number greater than or equal to 2) charging section and an nth charging section; and a second discharging step of applying a second discharging pulse between the nth charging section and an n+1th charging section.

A discharging rate of the second discharging pulse may be less than a discharging rate of the first discharging pulse.

A time at which the second discharging pulse is applied may be longer than a time at which the first discharging pulse is applied.

The discharging rate of the first or second discharging pulse and the time at which the first or second discharging pulse is applied may be set so that a discharging amount of the second discharging step is less than or equal to a discharging amount of the first discharging step.

A charging rate of the nth charging section may be less than a charging rate of the n-1th charging section.

Charging environments of the plurality of charging sections may be variably determined by a SOC value estimated based on a change in characteristic data of the battery according to charging.

The charging environment may be at least one of a length of each section of the plurality of charging sections and a charging rate of each section of the plurality of charging sections.

A battery charging apparatus according to another aspect of the present disclosure may comprise a charging unit configured to charge a battery; a discharging unit configured to discharge the battery; and a control unit configured to control the charging unit so that the battery is charged with a plurality of charging sections, and to control the discharging unit so that a first discharging pulse is applied between an n-1th (n is a natural number greater than or equal to 2) charging section and an nth charging section and a second discharging pulse is applied between the nth charging section and an n+1th charging section.

The control unit may be configured to control the discharging unit so that a discharging rate of the second discharging pulse is less than a discharging rate of the first discharging pulse.

The control unit may be configured to control the discharging unit so that a time at which the second discharging pulse is applied is longer than a time at which the first discharging pulse is applied.

The control unit may be configured to control the discharging rate of the first or second discharging pulse and the time at which the first or second discharging pulse is applied so that a discharging amount of the second discharging pulse is less than or equal to a discharging amount of the first discharging pulse.

The control unit may be configured to control the charging unit so that charging environments of the plurality of charging sections are variably set using a preset target SOC.

The target SOC may be estimated as a SOC value at which lithium is precipitated based on a change in characteristic data of the battery according to charging.

Advantageous Effects

According to the present disclosure, by dividing charging into a plurality of sections and applying a discharging processing that applies a discharging pulse between the charging sections, lithium precipitation may be minimized and the precipitated lithium may be removed more effectively.

In addition, according to one aspect of the present disclosure, by differentially applying the discharging environment, specifically the time at which the discharging pulse is applied and the discharging rate of the discharging pulse in a sequential discharging processing of each other performed in time series, the charging efficiency may be further improved, such as reduction of the charging time, and also the operating performance or durability of the battery may be further improved by delaying or slowing down the aging process of the battery.

Furthermore, according to one aspect of the present disclosure, by organically grafting the electrical characteristic data of the battery and variably setting the charging environment of each charging section that is divided into a plurality of sections and performed, a charging environment optimized for the state of the battery that changes over time may be implemented.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram showing a detailed configuration of a battery charging apparatus according to an embodiment of the present disclosure.

FIG. 2 is a block diagram showing a detailed configuration of a data operation unit.

FIG. 3 is a flowchart showing a processing process according to an embodiment of the present disclosure.

FIG. 4 is a flowchart showing a processing process according to another embodiment of the present disclosure.

FIG. 5 is a drawing explaining an embodiment of a discharging rate of a discharging pulse for each discharging section.

FIG. 6 is a drawing explaining an embodiment of the time at which the discharging pulse is applied for each discharging section.

FIGS. 7 and 8 are drawings explaining time-series characteristics of a discharging environment for each discharging section based on the entire charging process.

FIG. 9 is a drawing explaining the process of determining a SOC at which lithium is precipitated during charging.

FIG. 10 is a drawing showing the performance results of a battery according to the embodiment of the present disclosure based on the discharge capacity retention.

## BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

Throughout the specification, when a portion is referred to as "comprising" or "including" any element, it means that the portion may include other elements further, without excluding other elements, unless specifically stated otherwise.

Furthermore, the term "processor" described in the specification refers to a unit that processes at least one function or operation, and may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

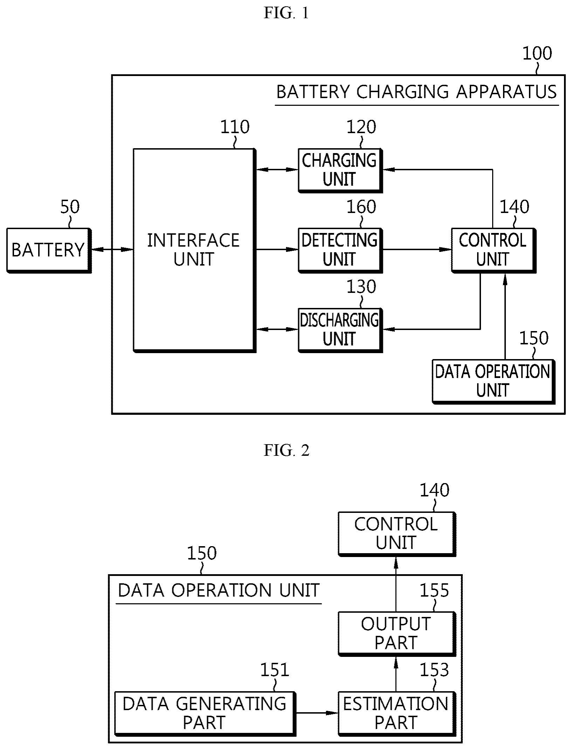

FIG. 1 is a block diagram showing a detailed configuration of a battery charging apparatus 100 according to an embodiment of the present disclosure.

As illustrated in FIG. 1, the battery charging apparatus 100 of the present disclosure may be configured to include an interface unit 110, a charging unit 120, a discharging unit 130, a control unit 140, and a detecting unit 160.

Prior to the detailed description of the present disclosure, the battery charging apparatus 100 according to the present disclosure may be implemented through various combinatorial applications of electronic components, parts, etc., such as storage means, operation processing means, and input/output means (ASIC, chipset, logic circuit, register, communication modem, MCU, etc.).

Therefore, each component of the battery charging apparatus 100 illustrated in FIG. 1 should be understood as a functionally or logically distinct component rather than a physically distinct component.

That is, since each component depicted in the drawings corresponds to a logical structure for effectively explaining the technical idea by the present disclosure, even if each component is configured integrated or separately, if the function performed by the logical structure of the present disclosure can be realized, it should be interpreted as being within the scope of the present disclosure, and if it is a component that performs the same or similar function, it should of course be interpreted as being within the scope of the present disclosure regardless of the consistency in their names. The same applies to the data operation unit 150 illustrated in FIG. 2.

In addition, the battery charging method of the present disclosure may be implemented as a set of processing or algorithm for data processing, handling, control, calculation, etc. as a whole, and thus, it may be implemented by a combination of the logical configurations shown in FIG. 1, as well as in the form of software installed and operated on a computer or a terminal, module, etc. equivalent thereto.

For example, the battery charging method may be applied to a BMS (Battery Management System). When the BMS is connected to a charging device, the battery may be rapidly charged by controlling charging and discharging of the battery using the battery charging method according to an embodiment of the present disclosure.

As another example, the battery charging method may be applied to a charging device. The charging device may rapidly charge a battery using the battery charging method according to an embodiment of the present disclosure.

The charging unit 120 of the present disclosure is electrically connected to the battery 50 and performs charging processing for the battery 50. According to an embodiment, the charging unit 120 of the present disclosure may be electrically connected to the battery 50 through an interface unit 110 linked to a physical means such as a jack or a socket, as illustrated in FIG. 1.

Since various types of secondary battery cells, cell banks, cell assemblies, cell modules, and battery packs may be targets of charging, the battery 50 in the following description may mean an object that collectively refers to cells, cell banks, cell assemblies, cell modules, and battery packs.

The discharging unit 130 of the present disclosure is configured to perform discharging on the battery 50, and may be electrically connected to the battery 50 through the interface unit 110, like the charging unit 120 described above, and of course, may be electrically connected to the battery 50 through an interface unit independent of the charging unit 120 depending on the embodiment.

The control unit 140 of the present disclosure is configured to be communicatively connected to the charging unit 120 and the discharging unit 130 and to control charging processing performed by the charging unit 120 and discharging processing performed by the discharging unit 130.

The battery charging apparatus 100 according to the present disclosure is configured to charge the battery 50 by dividing the charging section into k sections (k is a natural number greater than or equal to 2) without performing continuous charging processing from the start of charging to the end of charging (hereinafter referred to as 'multi-step charging mode').

The battery charging apparatus 100 according to the present disclosure is configured to charge a battery by dividing the charging section into a plurality of charging sections, so that a first discharging pulse is applied between the n-1th (where n is a natural number greater than or equal to 2) charging section and the nth charging section and a second discharging pulse is applied between the nth charging section and the n+1th charging section.

However, in one embodiment, the discharging pulse may not always be applied between each charging sections. For example, if the first discharging pulse is applied between the n-1th charging section and the nth charging section, the second discharging pulse may not be applied between the nth charging section and the n+1th charging section. Also, the third discharging pulse may be applied between the n+1th charging section and the n+2th charging section.

First, the overall charging process performed by the present disclosure will be described, and the specific details of each discharging mode or discharging processing performed by applying a discharging pulse will be described later.

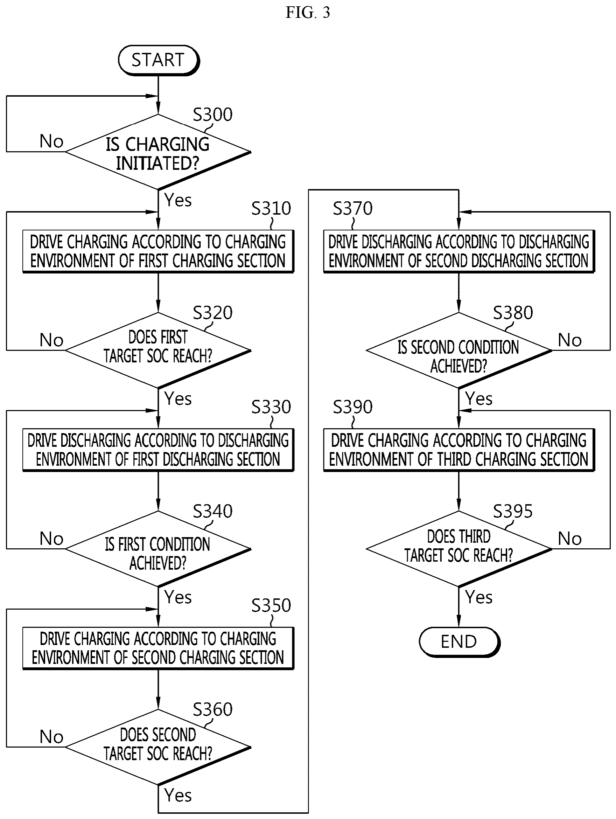

FIG. 3 is a flowchart illustrating the process of charging processing by the present disclosure, and illustrates the process of performing charging based on an embodiment in which the charging section is divided into three charging sections.

When a physical connection is made between the battery 50 and the charging unit 120 (or the interface unit 110), if charging is initiated by a method such as inputting an electrical signal or selecting a button or interface for initiating charging (S300), the control unit 140 of the present disclosure controls the charging unit 120 so that charging is driven according to the charging environment of the first charging section (S310).

The charging environment refers to the time at which charging is performed, that is, one or more of the length of the corresponding charging section, the size of the charging current, and the charging rate. It is preferable that the charging environment is variably set to reflect the current state of the battery 50, as described below. In the case of a multi-step charging method, it is preferable that the size of the charging current or the charging rate is set to decrease as it goes to a subsequent charging section.

When the SOC (State of Charge) of the corresponding battery 50 reaches the first target SOC by charging of the first charging section (hereinafter referred to as 'first charging'), the first charging is terminated (S320). Depending on the embodiment, the condition for terminating the first charging may be determined by whether the charging voltage of the battery 50 reaches the first threshold voltage, in addition to whether the SOC of the battery 50 reaches the first target SOC as described above.

After that, the control unit 140 of the present disclosure controls the discharging unit 130 to drive discharging according to the discharging environment of the first discharging mode for the battery 50 for which the first charging is completed (S330). The discharging environment means at least one of the size of the discharging pulse, the discharging rate of the discharging pulse, and the time at which the discharging pulse is applied.

When the discharging of the first discharging mode (hereinafter referred to as 'first discharging') satisfies the preset first condition (discharging time or current SOC of the battery 50, etc.) (S340), the control unit 140 of the present disclosure controls the discharging unit 130 to terminate the first discharging, and then controls the charging unit 120 to initiate charging of the second charging section (second charging) (S350).

As explained above, the second charging is also driven by a charging environment (one or more of the length of the charging section, the size of the charging current, and the charging rate) that is uniquely set in the second charging section itself.

When the SOC of the battery 50 reaches the second target SOC through charging by the second charging (S360), the control unit 140 of the present disclosure controls the charging unit 120 to terminate the second charging, and controls the discharging unit 130 to drive discharging according to the discharging environment of the second discharging mode (S370).

When the discharging of the second discharging mode (hereinafter referred to as 'second discharging') satisfies the preset second condition (discharging time or current SOC of the battery 50, etc.) (S380), the control unit 140 of the present disclosure controls the discharging unit 130 to terminate the second discharging and controls the charging unit 120 to initiate the charging of the third charging section (third charging) (S390).

When the SOC of the battery 50 reaches the third target SOC through charging by the third charging (S395), the entire charging processing by the present disclosure is terminated.

FIG. 3 is a processing process for an embodiment of the present disclosure, and it is obvious that charging may be performed by dividing the charging section into more charging sections depending on the embodiment. In the case of dividing charging section into more charging sections, discharging may be performed by applying a discharging pulse between at least two charging sections among the charging sections, and a resting period for a predetermined time may be applied between charging sections to which discharging processing is not applied to eliminate lithium precipitation.

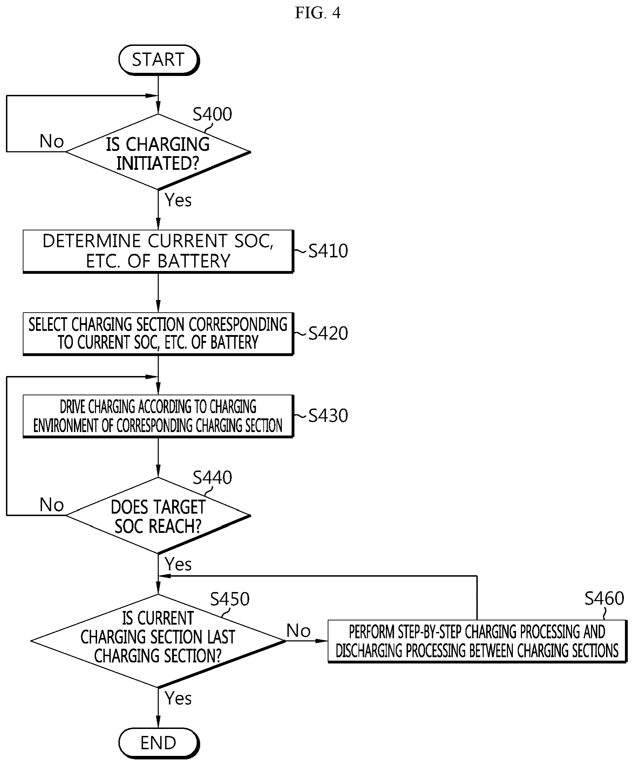

FIG. 4 is a flowchart showing a processing process according to another embodiment of the present disclosure.

The embodiment of the present disclosure described with reference to FIG. 3 above corresponds to an embodiment in which charging is performed to a battery 50 that is completely discharged or equivalent thereto, or charging is performed to a battery 50 corresponding to a lower SOC.

The embodiment illustrated in FIG. 4 corresponds to an embodiment that determines the current SOC of the battery 50, which is a target of charging, and performs charging by setting the charging section corresponding to the current SOC of the battery 50 among the charging sections divided into a plurality of sections as an initiation section of charging.

As described above, when a signal, etc. for charging initiation is input (S400), the detecting unit 160 of the present disclosure determines the current SOC of the battery 50 using the electrical characteristic values (voltage, etc.) of the battery 50 (S410), and outputs the result data to the control unit 140 of the present disclosure.

When data on the current SOC of the battery 50 is input, the control unit 140 of the present disclosure selects a charging section corresponding to the current SOC among the plurality of preset charging sections (S420), and controls the charging unit 120 to initiate charging with the charging environment (charging rate, size of charging current, etc.) of the selected charging section (S430).

After the SOC of the battery 50 reaches the target SOC according to the corresponding charging section (S440), if the performed current charging section is not the last charging section among the preset plurality of charging sections (S450), step-by-step charging and discharging processing between charging sections are cyclically performed as described with reference to FIG. 3, etc. (S460).

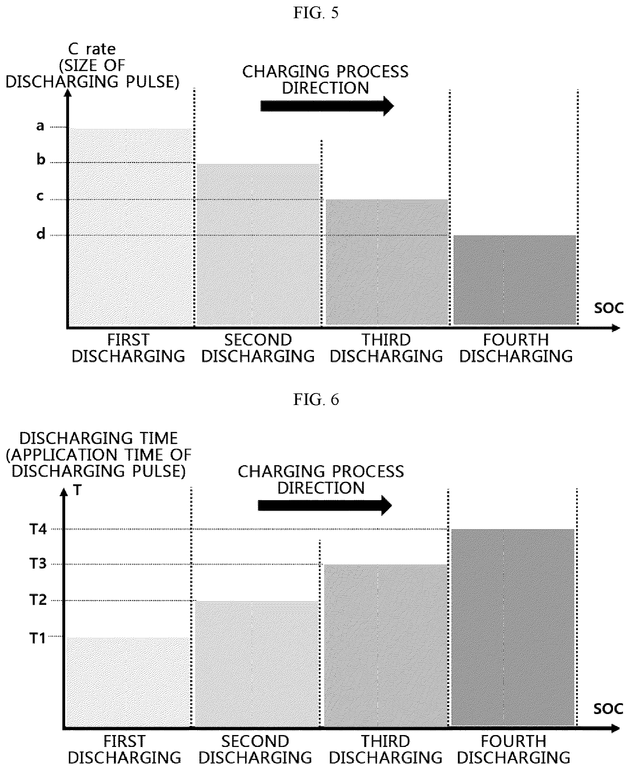

FIG. 5 is a drawing explaining an embodiment of a discharging rate of a discharging pulse for each discharging section, and FIG. 6 is a drawing explaining an embodiment of the time at which the discharging pulse is applied for each discharging section.

The embodiment illustrated in FIG. 5 corresponds to an embodiment in which four discharging processing are applied overall based on the SOC of the battery 50 that increases by charging.

Assuming that no discharging processing is applied after the last charging section, this embodiment may correspond to an embodiment that in which the battery 50 is charged with five or more charging sections. Assuming that all discharging processing is applied between the current charging section and the next charging section, based on the time series order of charging, the first discharging is applied between the first charging and the second charging, the second discharging is applied between the second charging and the third charging, the third discharging is applied between the third charging and the fourth charging, and finally, the fourth discharging is applied between the fourth charging and the fifth charging.

As illustrated in FIG. 5, it is preferable that the discharging rate (C-rate) of the first discharging pulse applied in the first discharging (discharging of the first discharging mode) is set to be the largest, and the discharging rate of the second discharging pulse applied in the second discharging subsequent to the first discharging is smaller than the discharging rate of the first discharging pulse. In addition, it is preferable that the discharging rate of the corresponding discharging mode gradually decreases as it goes to the third discharging and then the fourth discharging based on the time series order.

Based on the example of FIG. 5, b (discharging rate of the second discharging) is smaller than a (discharging rate of the first discharging) and larger than c (discharging rate of the third discharging). In addition, it is preferable that d (discharging rate of the fourth discharging) is smaller than c.

Specifically, it is preferable that the discharging rate of the first discharging pulse applied between the n-1th (where n is a natural number greater than or equal to 2) charging section and the nth charging section is greater than the discharging rate of the second discharging pulse applied between the nth charging section and the n+1th charging section. That is, it is preferable that the discharging rate of the second discharging pulse is less than the discharging rate of the first discharging pulse.

When configured in this way, the removal of lithium precipitated by charging of the corresponding charging section may be further accelerated, thereby more effectively suppressing performance deterioration of the battery 50.

Depending on the embodiment, as shown in FIG. 6, it is preferable that the discharging time (the time at which the discharging pulse is applied (the time at which discharging is performed)) of the subsequent discharging mode is greater than or equal to the discharging time of the previous discharging mode based on the time series order. For example, the discharging time of the current discharging mode may be equal to or greater than the discharging time of the previous discharging mode.

Based on the example of FIG. 6, T2 (the time at which the second discharging is performed) is longer than T1 (the time at which the first discharging is performed) and shorter than T3 (the time at which the third discharging is performed). In addition, it is preferable that T4 (the time at which the fourth discharging is performed) is longer than T3. However, although the embodiment of FIG. 6 illustrates an embodiment in which the discharging time of the nth discharging exceeds the discharging time of the n-1th discharging, as described above, an embodiment in which the discharging time of the nth discharging is equal to the discharging time of the n-1th discharging may also be applied.

Specifically, it is preferable that the application time of the first discharging pulse applied between the n-1th (where n is a natural number greater than or equal to 2) charging section and the nth charging section is shorter than or equal to the application time of the second discharging pulse applied between the nth charging section and the n+1th charging section. In other words, it is preferable that the application time of the second discharging pulse is longer than or equal to the application time of the first discharging pulse.

When configured in this manner, the removal of lithium precipitated by charging of the charging section may be induced more stably, thereby improving the charging efficiency of the battery 50 and effectively suppressing performance deterioration of the battery 50.

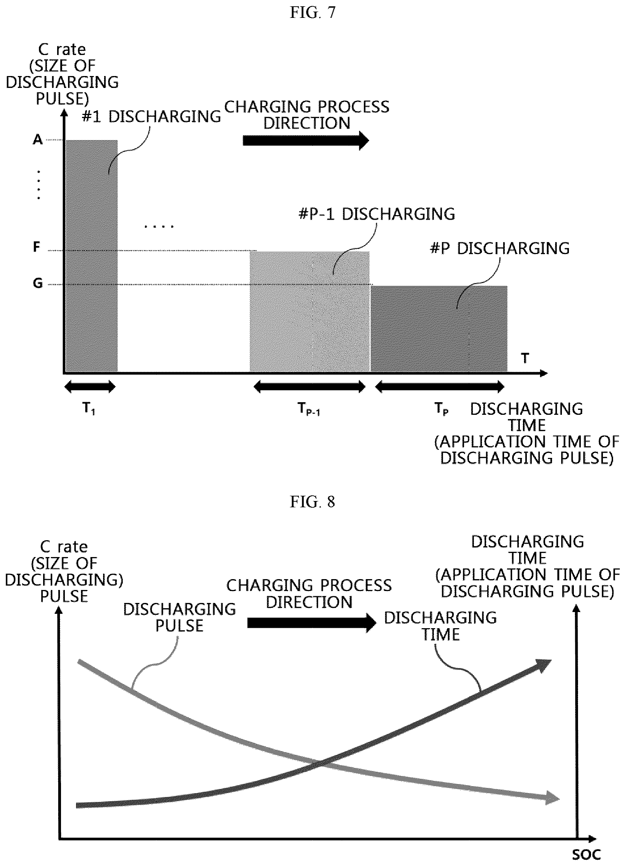

FIGS. 7 and 8 are drawings explaining time-series characteristics of a discharging environment for each discharging section based on the entire charging process.

In the embodiments of FIGS. 7 and 8, considering the charging progress direction, it is preferable that the size (discharging rate) of the discharging pulse of the discharging mode becomes smaller as it progresses to the subsequent discharging mode.

In addition, in the embodiment of FIGS. 7 and 8, considering the charging progress direction, it is preferable that the time at which the discharging pulse of the discharging mode is applied is the same or longer as it goes to a subsequent discharging mode. More preferably, it is preferable that the time at which the discharging pulse is applied becomes longer as it goes to a subsequent discharging mode.

Depending on the embodiment, it is preferable that the discharging rate of the discharging pulse and the application time of the discharging pulse are set so that the discharging amount of each discharging mode is the same or decreases as it progresses to a subsequent discharging mode.

For example, based on the embodiment illustrated in FIG. 7, the discharging amount of the first discharging may be defined by the multiplication operation of the discharging rate (A) of the discharging pulse and the application time ($T_1$) of the discharging pulse, so the discharging environment (the discharging rate of the discharging pulse and the application time of the discharging pulse) of each discharging mode may be set as a condition that satisfies Formula 1 below.

[Formula 1]

$$A \times T_1 \geq \cdots \geq F \times T_{P-1} \geq G \times T_P$$

In this respect, the control unit 140 of the present disclosure may be configured to control the discharging rate of the first or second discharging pulse and the time at which the first or second discharging pulse is applied so that the discharging amount of the second discharging pulse is less than or equal to the discharging amount of the first discharging pulse.

As described above, the first discharging pulse means a discharging pulse applied between the n-1th (where n is a natural number greater than or equal to 2) charging section and the nth charging section, and the second discharging pulse means a discharging pulse applied between the nth charging section and the n+1th charging section.

The control unit may be configured to control the charging unit so that the charging environments of the plurality of charging sections may be variably set using a preset target SOC.

Here, the charging environment of the charging section means one or more of the length of the charging section (the time at which charging is performed), the size of the charging current, and the charging rate.

Specifically, the target SOC may be estimated as a SOC value at which lithium is precipitated based on the change in characteristic data of the battery according to charging.

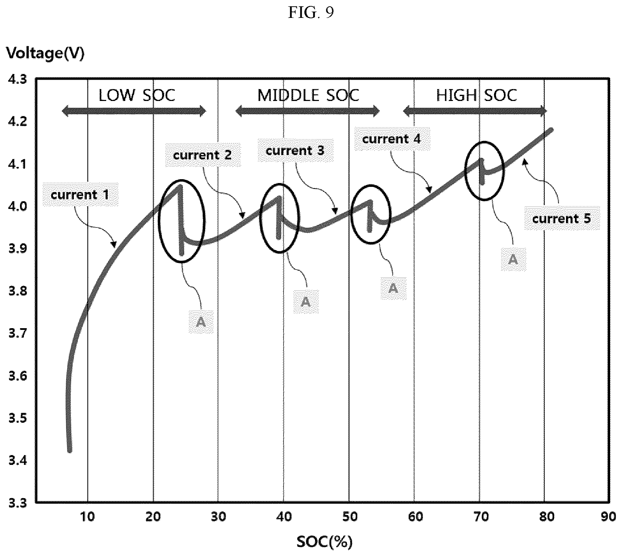

FIG. 9 is a profile showing the relationship between the SOC and voltage of the battery 50 according to charging. Specifically, the embodiment of FIG. 9 is a charging profile showing the corresponding relationship between the SOC and voltage of the battery when the battery is charged in a multi-step charging method according to an embodiment of the present disclosure.

More specifically, the embodiment of the present disclosure that sets up a plurality of charging sections, etc. by organically reflecting the current state (deterioration level, SOH (State of health), etc.) of the battery 50 will be explained in detail.

FIG. 2 is a block diagram showing a detailed configuration of the data operation unit 150.

Referring to FIG. 2, the data operation unit 150 may be configured to include a data generating part 151, an estimation part 153, and an output part 155, and corresponds to a configuration that estimates a SOC value at which lithium is precipitated during a charging process and outputs data thereon to the control unit 140 of the present disclosure.

When the target SOC estimated as the SOC value at which lithium is precipitated is input to the control unit 140, the control unit 140 may variably set the charging environments of a plurality of charging sections based on the target SOC. In addition, the control unit 140 may control the charging unit 120 and the discharging unit 130 based on the target SOC.

The data generating part 151, which is a component of the data operation unit 150, is configured to generate characteristic data of the battery 50 according to charging. The characteristic data may include the voltage of the battery 50, the voltage change rate, the voltage increase rate (slope value), the change rate of the voltage increase rate (change rate of the slope value), etc.

The target battery 50 for which characteristic data is generated may be a non-degenerated battery (e.g., a BOL (Beginning of life) battery) with specifications equivalent to those of the battery 50 currently being charged, as well as multiple batteries classified by SOH.

When the characteristic data is generated, the estimation part 153 of the present disclosure estimates the target SOC (A, FIG. 9) at which lithium is precipitated based on the characteristic data or the change in characteristic data, and the output part 155 of the data operation unit 150 outputs the target SOC to the control unit 140. Of course, the target SOC (A) may be plural as shown in FIG. 9.

When the target SOC is input in this way, the control unit 140 variably sets the points at which the charging environment and discharging mode of the plurality of charging sections are applied using multiple target SOCs. It is desirable that the target SOC, as well as the setting data for the charging environment determined by the target SOC, is utilized to be organized into a database linked to the deterioration degree of the battery 50.

In the embodiment of FIG. 1, the data operation unit 150 is described as being included in the battery charging apparatus 100 according to an embodiment of the present disclosure. However, the data operation unit 150 may be configured as a separate device provided externally to the battery charging apparatus 100. In this case, the data operation unit 150 may be connected to the control unit 140 via wired and/or wireless communication, and may transmit information about the target SOC to the control unit 140. For example, the data operation unit 150 may be a cloud computing device that estimates the target SOC for each battery by considering the degree of degradation of the battery, etc., and stores the estimated target SOC in a database.

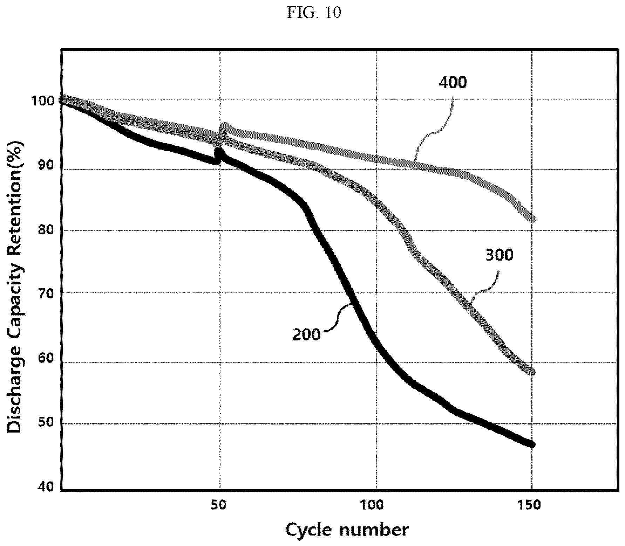

FIG. 10 is a diagram showing the performance results of a battery according to the embodiment of the present disclosure based on the discharge capacity retention. As is well known, a battery has a behavioral characteristic in which its discharge capacity retention decreases as use (charging and discharging) continues or is repeated.

In FIG. 10, 200 is a behavior characteristic graph of a battery to which only a common condition is applied that charges at a charging rate (charging current size) that decreases as it proceeds to a subsequent charging section. In FIG. 10, 300 is a behavior characteristic graph of a battery to which a condition that a discharging pulse between charging sections is applied so that a discharging pulse having the same discharging rate and the same discharging pulse is applied for the same time to all discharging modes is applied together with the common condition. In FIG. 10, 400 is a behavior characteristic graph of a battery to which a condition that a discharging pulse is applied between charging sections so that the discharging rate decreases and the time at which the discharging pulse is applied becomes longer as it proceeds to a subsequent discharging mode is applied together with the common condition.

As shown in FIG. 10, in the case of 400, to which processing by a preferred embodiment of the present disclosure is applied, it may be confirmed that the durability and performance maintenance rate of the battery 50 itself are clearly improved as the performance degradation is significantly delayed or slowed down compared to 200 and 300.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

The drawings or the like attached for explaining the present disclosure and illustrating examples thereof may be illustrated in a somewhat exaggerated form in order to emphasize or highlight the technical content of the present disclosure. However, it should be interpreted that it is obvious that various modified examples are possible at the level of a person skilled in the art by considering the previously described content and matters illustrated in the drawings.

In addition, it is self-evident that expressions such as first, second, upper, lower, or top and bottom in the explanation of the present disclosure are merely instrumental concept terms used to relatively distinguish components (elements) from each other, and are not terms used to indicate a specific order, priority, or the like, or terms used to physically distinguish each component (element) on an absolute basis.

(Explanation of reference signs)

100: battery charging apparatus
110: interface unit
120: charging unit
130: discharging unit
140: control unit
150: data operation unit
151: data generating part
153: estimation part
155: output part
160: detecting unit

**Claims**

1.  A battery charging method of charging a battery by dividing a charging section into a plurality of charging sections, the battery charging method comprising:

    a first discharging step of applying a first discharging pulse between an n-1th (n is a natural number greater than or equal to 2) charging section and an nth charging section;
    and
    a second discharging step of applying a second discharging pulse between the nth charging section and an n+1th charging section,
    wherein a discharging rate of the second discharging pulse is less than a discharging rate of the first discharging pulse.

2.  The battery charging method according to claim 1,
    wherein a time at which the second discharging pulse is applied is longer than a time at which the first discharging pulse is applied.

3.  The battery charging method according to claim 2,
    wherein the discharging rate of the first or second discharging pulse and the time at which the first or second discharging pulse is applied are set so that a discharging amount of the second discharging step is less than or equal to a discharging amount of the first discharging step.

4.  The battery charging method according to claim 1,
    wherein a charging rate of the nth charging section is less than a charging rate of the n-1th charging section.

5.  The battery charging method according to claim 1,
    wherein charging environments of the plurality of charging sections are variably determined by a SOC value estimated based on a change in characteristic data of the battery according to charging.

6.  The battery charging method according to claim 5,
    wherein the charging environment is at least one of a length of each section of the plurality of charging sections and a charging rate of each section of the plurality of charging sections.

7.  A battery charging apparatus comprising:

    a charging unit configured to charge a battery;
    a discharging unit configured to discharge the battery; and
    a control unit configured to control the charging unit so that the battery is charged with a plurality of charging sections, and to control the discharging unit so that a first discharging pulse is applied between an n-1th (n is a natural number greater than or equal to 2) charging section and an nth charging section and a second discharging pulse is applied between the nth charging section and an n+1th charging section,
wherein the control unit is configured to control the discharging unit so that a discharging rate of the second discharging pulse is less than a discharging rate of the first discharging pulse.

8. The battery charging apparatus according to claim 7,
wherein the control unit is configured to control the discharging unit so that a time at which the second discharging pulse is applied is longer than a time at which the first discharging pulse is applied.

9. The battery charging apparatus according to claim 8,
wherein the control unit is configured to control the discharging rate of the first or second discharging pulse and the time at which the first or second discharging pulse is applied so that a discharging amount of the second discharging pulse is less than or equal to a discharging amount of the first discharging pulse.

10. The battery charging apparatus according to claim 7,

wherein the control unit is configured to control the charging unit so that charging environments of the plurality of charging sections are variably set using a preset target SOC,
and
wherein the target SOC is estimated as a SOC value at which lithium is precipitated based on a change in characteristic data of the battery according to charging.

FIG. 1

BATTERY CHARGING APPARATUS 100

FIG. 2

FIG. 3

FIG. 4

FIG. 5

FIG. 6

FIG. 7

FIG. 8

EP 4 661 242 A1

FIG. 9

16

FIG. 10

## INTERNATIONAL SEARCH REPORT

| | |
|---|---|
| International application No. | |
| | **PCT/KR2024/010574** |

| | |
|---|---|
| **A.** | **CLASSIFICATION OF SUBJECT MATTER** |

**H02J 7/00**(2006.01)i; **H01M 10/44**(2006.01)i; **B60L 53/60**(2019.01)i; **G01R 31/36**(2006.01)i; **G01R 31/382**(2019.01)i; **G01R 31/396**(2019.01)i

According to International Patent Classification (IPC) or to both national classification and IPC

| | |
|---|---|
| **B.** | **FIELDS SEARCHED** |

Minimum documentation searched (classification system followed by classification symbols)

H02J 7/00(2006.01); H01M 10/44(2006.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전(charging), 방전(discharging), 펄스(pulse), 시간(time), SOC(State Of Charge)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | WO 2023-077444 A1 (CONTEMPORARY AMPEREX TECHNOLOGY CO., LIMITED) 11 May 2023 (2023-05-11)<br>See page 6, line 1 - page 10, line 26; claims 1-2; and figures 1-2. | 1-10 |
| Y | KR 10-2023-0107638 A (CONTEMPORARY AMPEREX TECHNOLOGY CO., LIMITED) 17 July 2023 (2023-07-17)<br>See paragraphs [0022], [0060]-[0102] and [0198]-[0212]; claim 11; and figures 1-8. | 1-10 |
| A | JP 2022-548505 A (BAYERISCHE MOTOREN WERKE AKTIENGESELLSCHAFT) 21 November 2022 (2022-11-21)<br>See paragraphs [0055]-[0062]; and figure 2. | 1-10 |
| A | JP 2020-078179 A (FURUKAWA ELECTRIC CO., LTD. et al.) 21 May 2020 (2020-05-21)<br>See paragraphs [0036]-[0048]; and figure 6. | 1-10 |
| A | KR 10-2019-0054513 A (LG CHEM, LTD.) 22 May 2019 (2019-05-22)<br>See paragraphs [0044]-[0065]; and figures 2-6. | 1-10 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **29 October 2024** | **01 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT<br>Information on patent family members | | | | International application No.<br>**PCT/KR2024/010574** | | |
|---|---|---|---|---|---|---|

| Patent document<br>cited in search report | | | Publication date<br>(day/month/year) | Patent family member(s) | | | Publication date<br>(day/month/year) |
|---|---|---|---|---|---|---|---|
| WO | 2023-077444 | A1 | 11 May 2023 | CN | 116406482 | A | 07 July 2023 |
| | | | | EP | 4280340 | A1 | 22 November 2023 |
| | | | | EP | 4280340 | A4 | 15 May 2024 |
| | | | | JP | 2024-505879 | A | 08 February 2024 |
| | | | | KR | 10-2023-0125030 | A | 28 August 2023 |
| | | | | US | 2023-0396089 | A1 | 07 December 2023 |
| KR | 10-2023-0107638 | A | 17 July 2023 | CN | 116097541 | A | 09 May 2023 |
| | | | | CN | 116097541 | B | 02 February 2024 |
| | | | | EP | 4231412 | A1 | 23 August 2023 |
| | | | | EP | 4231412 | A4 | 21 February 2024 |
| | | | | JP | 2023-553499 | A | 21 December 2023 |
| | | | | US | 2023-0402868 | A1 | 14 December 2023 |
| | | | | WO | 2023-035161 | A1 | 16 March 2023 |
| JP | 2022-548505 | A | 21 November 2022 | CN | 114303296 | A | 08 April 2022 |
| | | | | DE | 102019123739 | A1 | 04 March 2021 |
| | | | | KR | 10-2022-0035216 | A | 21 March 2022 |
| | | | | US | 2022-0311262 | A1 | 29 September 2022 |
| | | | | WO | 2021-043563 | A1 | 11 March 2021 |
| JP | 2020-078179 | A | 21 May 2020 | JP | 7254482 | B2 | 10 April 2023 |
| KR | 10-2019-0054513 | A | 22 May 2019 | CN | 110313099 | A | 08 October 2019 |
| | | | | CN | 110313099 | B | 05 July 2022 |
| | | | | EP | 3579329 | A1 | 11 December 2019 |
| | | | | EP | 3579329 | A4 | 13 May 2020 |
| | | | | EP | 3579329 | B1 | 21 April 2021 |
| | | | | JP | 2020-515207 | A | 21 May 2020 |
| | | | | JP | 6797438 | B2 | 09 December 2020 |
| | | | | KR | 10-2441469 | B1 | 06 September 2022 |
| | | | | US | 11081735 | B2 | 03 August 2021 |
| | | | | US | 2021-0104782 | A1 | 08 April 2021 |
| | | | | WO | 2019-093654 | A1 | 16 May 2019 |
| | | | | WO | 2019-093654 | A8 | 06 September 2019 |

Form PCT/ISA/210 (patent family annex) (July 2022)

**EP 4 661 242 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230098508